Europäisches Patentamt

European Patent Office

Office européen des brevets

(19)

(11) Publication number: **0 298 429**
**A2**

(12) # EUROPEAN PATENT APPLICATION

(21) Application number: **88110723.9**

(51) Int. Cl.⁴: **H03M 1/38**

(22) Date of filing: **05.07.88**

(30) Priority: **08.07.87 JP 170201/87**

(43) Date of publication of application:
**11.01.89 Bulletin 89/02**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Goto, Junkei**
**c/o Patent Division Kabushiki Kaisha**
**Toshiba**
**1-1 Shibaura 1-chome Minato-ku Tokyo**
**105(JP)**
Inventor: **Iida, Tetsuya**
**c/o Patent Division Kabushiki Kaisha**
**Toshiba**
**1-1 Shibaura 1-chome Minato-ku Tokyo**
**105(JP)**

(74) Representative: **Henkel, Feiler, Hänzel &**
**Partner**
**Möhlstrasse 37**
**D-8000 München 80(DE)**

(54) **Successive approximation A/D converter.**

(57) A successive approximation A/D converter of this invention is characterized in that a plurality of amplifiers ($A_1$, $A_2$) are cascade-connected as a voltage approximation inversion amplifier ($A_0$) in which an amplifier having a low output impedance constitutes a final stage of the plurality of amplifiers ($A_1$, $A_2$), and at least one amplifier ($A_1$) having a high voltage gain constitutes a stage preceding the amplifier having the low output impedance. According to the successive approximation A/D converter of this invention, since the inversion amplifier ($A_0$) has a high voltage gain and a low output impedance, high-speed, high-precision A/D conversion can be realized.

F I G. 5

## Successive approximation A/D converter

The present invention relates to an A/D converter used in various electronic devices and, more particularly, to an integrated circuit of a successive approximation A/D converter.

In general, a successive approximation A/D converter supplies a successive approximation control digital output from a successive approximation control circuit to a local D/A converter to cause it to generate a local analog voltage while the A/D converter samples and retains an analog voltage input. The A/D converter then compares the retained analog voltage with the local analog voltage, and successively determines the values of bits of an A/D conversion output from the successive approximation control circuit based on the comparison result. Thus, an A/D conversion output of a plurality of bits can be obtained from the successive approximation control circuit.

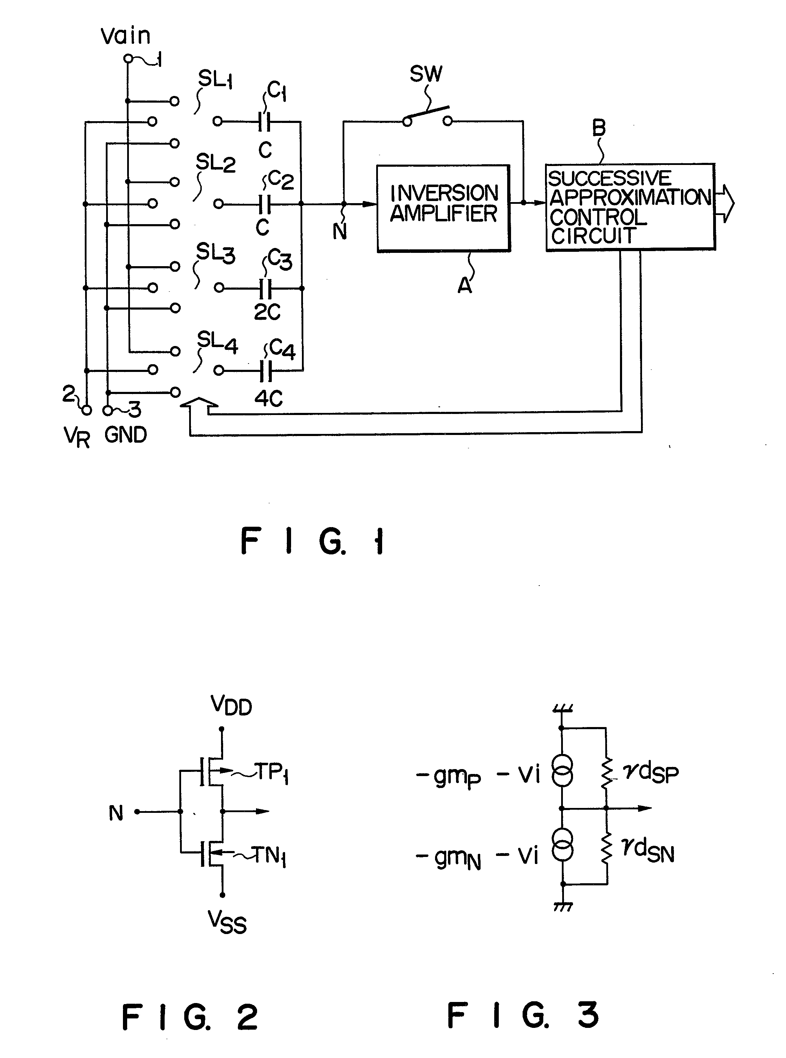

Fig. 1 shows a 3-bit A/D converter as an example of a successive approximation A/D converter. More specifically, reference symbols $C_1$ and $C_2$ denote capacitors each having reference capacitance C; $C_3$, a capacitor having capacitance 2C; and $C_4$, a capacitor having capacitance 4C. Reference symbol A denotes an inversion amplifier; and SW, a switch circuit. Amplifier A and switch circuit SW form a voltage comparator. Reference numeral 1 denotes an analog input terminal; 2, a reference voltage terminal; 3, a ground terminal; $SL_1$ to $SL_4$, selection circuits whose selective connection states are controlled by the successive approximation control digital signal. Reference symbol B denotes a successive approximation control circuit. Control circuit B has functions for successively outputting the successive approximation control digital signal and successively determining the bit values of an A/D conversion output based on the logic level of the output from inversion amplifier A.

An A/D conversion operation of the successive approximation A/D converter will be described below. In a sample mode, switch circuit SW is controlled to be ON, and selection circuits $SL_1$ to $SL_4$ are controlled to select the analog input terminal. In this case, a potential at input terminal node of inversion amplifier A becomes threshold voltage Vop thereof. If the analog input voltage is given as Vain, charge $Q_s$ accumulated in capacitors $C_1$ to $C_4$ is expressed as follows:

$$Q_s = (V_{op} - V_{ain}) \cdot 8C \qquad (1)$$

An approximation mode is then selected. Switch circuit SW is controlled to be OFF, selection circuits $SL_1$ to $SL_3$ are controlled to select the ground terminal, and selection circuit SL4 is controlled to select the reference voltage terminal. In this case, if a potential at node N is given as $V_1$, charge $Q_1$

accumulated in capacitors $C_1$ to $C_3$ and charge $Q_2$ accumulated in capacitor $C_4$ are respectively expressed as follows:

$$Q_1 = (C + C + 2C) \cdot V_1 \qquad (2)$$
$$Q_2 = 4C \cdot (V_1 - V_R) \qquad (3)$$

Since a charge conservation condition represented by the following equation is established at node N:

$$Q_s = Q_1 + Q_2 \qquad (4)$$

then, equations (1), (2), and (3) are substituted in equation (4):

$$(V_{op} - V_{ain}) \cdot 8C = 4CV_1 + 4C \cdot (V_1 - V_R) = 8CV_1 - 4CV_R$$

$$V_{op} - V_{ain} = V_1 - (1/2)V_R \quad V_1 - V_{op} = (1/2)V_R - V_{ain} \qquad (5)$$

In equation (5), when $(1/2)V_R > V_{ain}$, $V_1 > V_{op}$ is established. Therefore, the output from inversion amplifier A rises to the L level. When $(1/2)V_R < V_{ain}$, $V_1 < V_{op}$ is established. Therefore, the output from inversion amplifier A rises to H level. Successive approximation control circuit B determines the value ("1" or "0") of the MSB (Most Significant Bit) of the digital output in accordance with the output from inversion amplifier A, and then supplies to selection circuits $SL_1$ to $SL_4$ a control signal for performing an approximation operation corresponding to the next bit. In this manner, an operation wherein control circuit B outputs, after successive approximation, a given successive approximation control signal, a value of a given bit is determined in accordance with the output from inversion amplifier A and repeated a predetermined number of times (in this case, three times), thereby determining a 3-bit A/D conversion output.

In the successive approximation A/D converter described above, in order to perform high-speed A/D conversion, operations in the sample and approximation modes must be performed at high speed. For this purpose, output impedance $Z_{out}$ of inversion amplifier A must be decreased. In order to perform high-precision A/D conversion, voltage gain K of inversion amplifier A must be increased.

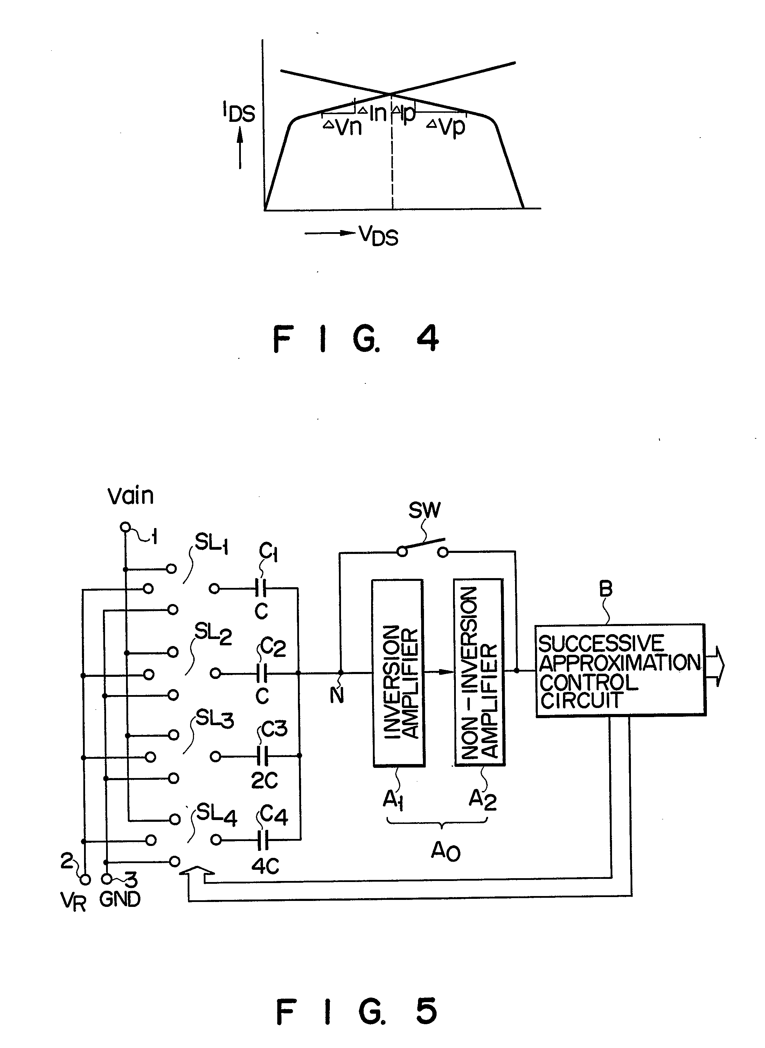

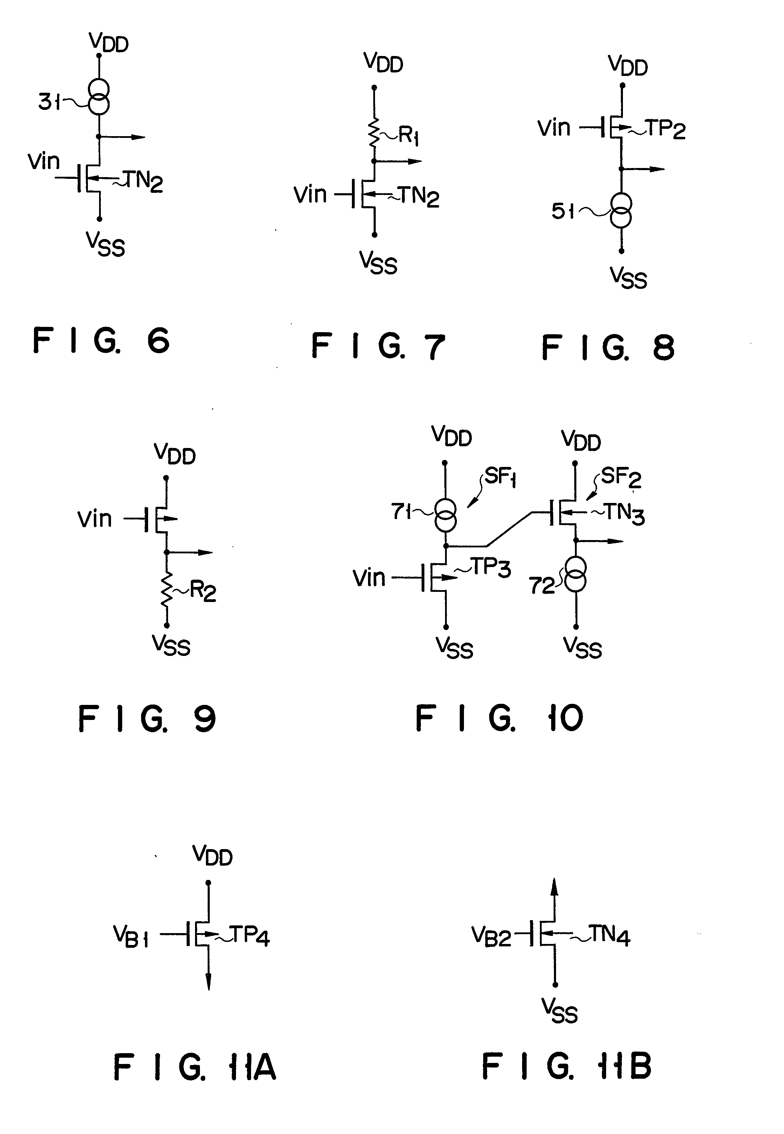

However, conventional inversion amplifier A comprises, e.g., only one CMOS inverter shown in Fig. 2. With this inverter, if voltage gain K is increased, output impedance $Z_{out}$ is increased accordingly. Contrary to this, if output impedance $Z_{out}$ is decreased, voltage gain K is decreased accordingly. Therefore, requirements for voltage gain K and output impedance $Z_{out}$ cannot be simultaneously satisfied. More specifically, in the CMOS inverter shown in Fig. 2, p- and n-channel MOS transistors $TP_1$ and $TN_1$ are connected in series with each other between a $V_{DD}$ power supply node and a $V_{SS}$ power supply node (e.g., a ground terminal). The gates of transistors $TP_1$ and $TN_1$ are

connected to input node N, and a node between the drains thereof serves as an output node. Fig. 3 shows an equivalent circuit of the CMOS inverter. Reference symbols $g_{mP}$ and $r_{dsP}$ denote a transconductance and saturation drain resistance of p-channel transistor $TP_1$, respectively; $g_{mN}$ and $r_{dsN}$, a transconductance and a saturation drain resistance of n-channel transistor $TN_1$, respectively. Fig. 4 shows drain-source voltage $V_{DS}$ vs. drain-source current $I_{DS}$ characteristics for transistors $TP_1$ and $TN_1$. Voltage gain K in the CMOS inverter is expressed by:

$$K = gm \cdot r_{ds} \qquad (6)$$

for

$$g_m = g_{mP} + g_{mN} \qquad (7)$$

$$r_{ds} = (r_{dsP} \cdot r_{dsN})/(r_{dsP} + r_{dsN}) \qquad (8)$$

Output impedance $Z_{out}$ is expressed by:

$$Z_{out} = r_{ds} \qquad (9)$$

From Fig. 4, resistances $r_{dsP}$ and $r_{dsN}$ are respectively expressed by:

$$r_{dsP} = \Delta V_P / \Delta I_P \qquad (10)$$

$$r_{dsN} = \Delta V_N / \Delta I_N \qquad (11)$$

where $\Delta V_P$ and $\Delta V_N$ are respectively small changes in voltage applied to transistors TP1 and $TN_1$, and $\Delta I_P$ and $\Delta I_N$ are respectively small changes in currents flowing through transistors $TP_1$ and $TN_1$. Therefore, if the channel lengths of transistors $TP_1$ and $TN_1$ are reduced, $\Delta V_P / \Delta I_P$ and $\Delta V_N / \Delta I_N$ are decreased by channel-length modulation, and output impedance $Z_{out}$ voltage gain K are also decreased. Contrary to this, if the channel lengths of transistors $TP_1$ and $TN_1$ are increased, voltage gain K is increased, and output impedance $Z_{out}$ is also increased.

In the conventional successive approximation A/D converter, requirements for the voltage gain and output impedance of a voltage approximation inversion amplifier cannot be simultaneously satisfied, and it is difficult to achieve high-speed A/D conversion.

It is an object of the present invention to provide a successive approximation A/D converter which is capable of realizing a high-speed, high-precision A/D conversion thru use of an inversion amplifier having a high voltage gain and a low output impedance.

In a successive approximation A/D converter of the present invention, a plurality of amplifiers are cascade-connected as a voltage approximation inversion amplifier. An amplifier having a low output impedance constitutes a final stage of the plurality of amplifiers, and at least one amplifier having a high voltage gain constitutes a stage which precedes the amplifier having the low output impedance.

According to the successive approximation A/D converter of the present invention, a high-speed, high-precision A/D conversion can be realized, since an inversion amplifier having a high voltage gain and a low output impedance is used.

This invention can be more fully understood from the following detailed description when taken in conjunction with the accompanying drawings, in which:

Fig. 1 is a block diagram showing a conventional successive approximation A/D converter;

Fig. 2 is a diagram showing an inversion amplifier of the A/D converter shown in Fig. 1, which comprises a CMOS inverter;

Fig. 3 is a circuit diagram showing a circuit of the inversion amplifier which is equivalent to that shown in Fig. 2;

Fig. 4 is a graph showing source-drain voltage vs. drain-source current characteristics for p- and n-channel transistors constituting a CMOS inverter when the inversion amplifier shown in Fig. 2 comprises the CMOS inverter;

Fig. 5 is a block diagram showing a successive approximation A/D converter according to the present invention;

Figs. 6 to 9 are detailed circuit diagrams showing different arrangements of a first amplifier constituting an inversion amplifier in the A/D converter of the present invention shown in Fig. 5;

Fig. 10 is a detailed circuit diagram of a second amplifier constituting the inversion amplifier in the A/D converter of the present invention shown in Fig. 5;

Figs. 11A and 11B are detailed circuit diagrams of first and second current source circuits shown in Fig. 10, respectively;

Figs. 12 to 14 are detailed circuit diagrams showing different arrangements of the second amplifier constituting the inversion amplifier in the A/D converter of the present invention shown in Fig. 5; and

Fig. 15 is a circuit diagram showing another embodiment of a successive approximation A/D converter according to the present invention.

An embodiment of the present invention will be described with reference to the accompanying drawings.

Fig. 5 shows a 3-bit successive approximation A/D converter formed on a MOS (insulating gate type) integrated circuit. More specifically, reference symbols $C_1$ and $C_2$ denote capacitors each having a reference capacitance of C; $C_3$, a capacitor having a capacitance of 2C; and $C_4$, a capacitor having a capacitance of 4C. The other end of each of these capacitors $C_1$ to $C_4$ is connected to the input terminal (node N) of amplifier $A_0$. Switch circuit SW is connected between the input and output terminals of amplifier $A_0$. Amplifier $A_0$ and switch circuit SW form a voltage comparator. Reference symbols SL1 to SL4 denote selection circuits for performing selection so that one end of each of capacitors C1 to C4 is connected to one of analog input terminal 1, reference voltage terminal 2, and ground terminal 3. These selection circuits are controlled by a successive approximation control digital signal output from successive approximation control circuit B (to be described later). Capacitors $C_1$ to $C_4$ and selection circuits $SL_1$ to $SL_4$ form a circuit for sampling and holding analog voltage input $V_{ain}$ at analog input terminal 1, and a capacitor-array charge re-distribution type local D/A converter for performing D/A (digital-to-analog) conversion in accordance with the successive approximation control digital signal output. Successive approximation control circuit B successively determines bit values of an A/D conversion output based on the output from amplifier $A_0$, and outputs a successive approximation control signal for successively generating a local analog voltage necessary for successive approximation.

In this embodiment, amplifier $A_0$ is constituted by cascade-connecting first inversion amplifier $A_1$ having a high voltage gain and second noninversion amplifier $A_2$ having a low output impedance.

Various detailed arrangements of inversion amplifier AI will be described with reference to Fig. 2 and Figs. 6 to 9. More specifically, the inversion amplifier shown in Fig. 2 comprises a CMOS inverter using p- and n-channel transistors $TP_1$ and $TN_1$, as described above. The channel lengths of transistors $TP_1$ and $TN_1$ are set to be long so that high voltage gain K can be obtained.

An inversion amplifier shown in Fig. 6 comprises a drain follower circuit in which current source circuit 31 and n-channel transistor $TN_2$, the gate of which receives input voltage $V_{in}$, are connected in series with each other between $V_{DD}$ and $V_{SS}$ power supply nodes. The drain of transistor $TN_2$ serves as an output node.

An inversion amplifier shown in Fig. 7 comprises a drain follower circuit in which current source circuit 31 of the inversion amplifier shown in Fig. 6 is realized by resistor $R_1$.

An inversion amplifier shown in Fig. 8 comprises a drain follower circuit in which p-channel transistor $TP_2$, the gate of which receives input voltage $V_{in}$, and current source circuit 51 are connected in series with each other between $V_{DD}$ and $V_{SS}$ power supply nodes. The drain of transistor $TP_2$ serves as an output node.

An inversion amplifier shown in Fig. 9 comprises a drain follower circuit in which current source circuit 51 of the inversion amplifier shown in Fig. 8 is realized by resistor $R_2$.

In the inversion amplifier arrangements shown in Figs. 6 to 9, either transistor $TN_2$ or $TP_2$ is set to have a large transconductance, thereby obtaining a high voltage gain.

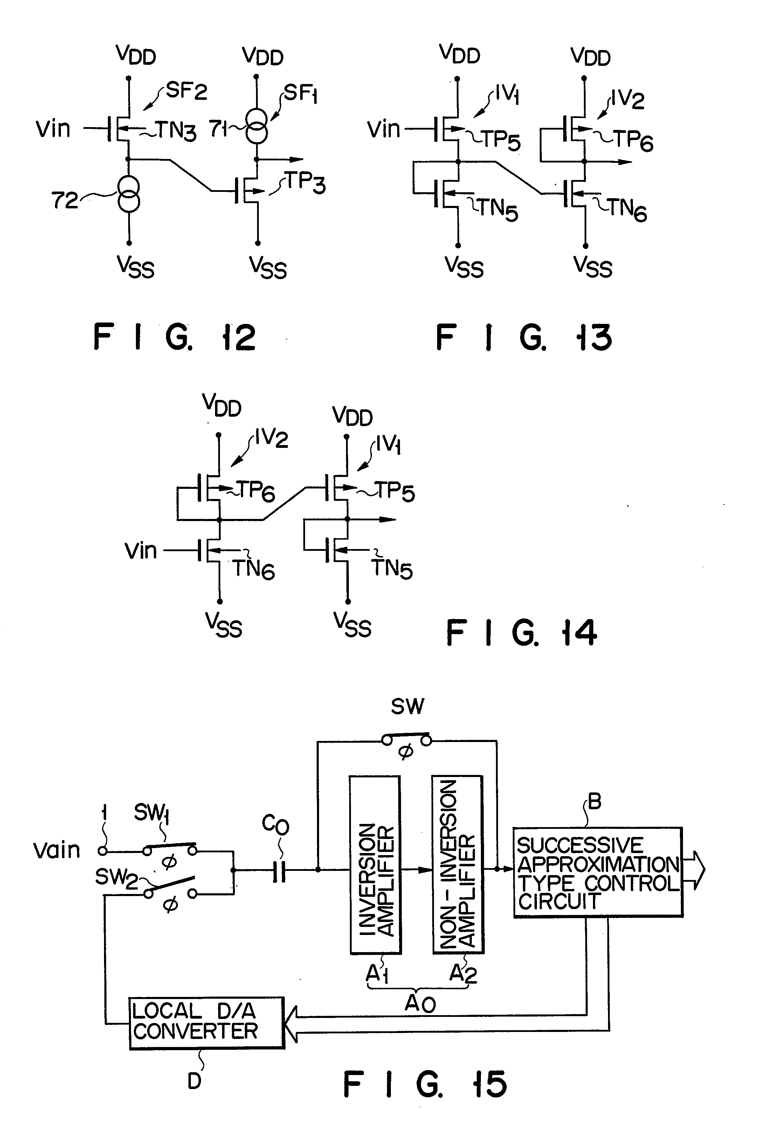

Detailed arrangements of noninversion amplifier $A_2$ will be described below with reference to Figs. 10 to 13. More specifically, a noninversion. amplifier shown in Fig. 10 comprises first source follower circuit SF1 in which first current source circuit 71 and p-channel transistor $TP_3$, the gate of which receives input voltage $V_{in}$, are connected in series with each other between $V_{DD}$ and $V_{SS}$ power supply nodes, and second source follower circuit in which n-channel transistor $TN_3$, the gate of which is connected to the source of transistor $TP_3$, and second current source circuit 72 are connected in series with each other between the $V_{DD}$ and $V_{SS}$ power supply nodes. First current source circuit 71 comprises p-channel transistor $TP_4$, the gate of which receives bias voltage $VB_1$ and the source of which is connected to the $V_{DD}$ power supply node, as shown in Fig. 11A. Second current source circuit 72 comprises n-channel transistor $TN_4$, the gate of which receives bias voltage $VB_2$ and the source of which is connected to the $V_{SS}$ power supply node, as shown in Fig. 11B.

In the noninversion amplifier shown in Fig. 7, when the transconductance, the saturation drain resistance, a small change in gate input voltage, and a small change in source output voltage of p-channel transistor $TP_3$ are respectively given as $g_{mP}$, $r_{dsP}$, $\Delta V_{inP}$, and $\Delta V_{outP}$, and when the transconductance, the saturation drain resistance, a small change in gate input voltage, and a small change in source output voltage of n-channel transistor $TN_3$ are respectively given as $g_{mN}$, $r_{dsN}$, $\Delta V_{inN}$, and $\Delta V_{outN}$, the following equations are established:

$$g_{mP}(\Delta V_{inP} - \Delta V_{outP}) = \Delta V_{outP}/r_{dsP} \quad (12)$$
$$g_{mN}(\Delta V_{inN} - \Delta V_{outN}) = \Delta V_{outN}/r_{dsN} \quad (13)$$

From equations (12) and (13), the voltage gains of the first and second source follower circuits are respectively expressed by:

$$\Delta V_{outP}/\Delta V_{inP} = (g_{mP} \cdot r_{dsP})/(1 + g_{mP} \cdot r_{dsP}) \simeq 1 \quad (14)$$
$$\Delta V_{outN}/\Delta V_{inN} = (g_{mN} \cdot r_{dsN})/(1 + g_{mN} \cdot r_{dsN}) \simeq 1 \quad (15)$$

The voltage gain of the noninversion amplifier is 1. Output impedance Zout is given by:

$$Z_{out} = r_{dsN} = 1/g_{mN} \quad (16)$$

for $g_{mN} = \sqrt{2\beta I_0}$

$$\beta = (W/L) \cdot (\mu \epsilon_{0x}/T_{0x})$$

where $I_0$ is a current from second current source circuit 72, $\beta$ is a current amplification factor of a MOS transistor, and W and L are respectively a channel width and a channel length of the MOS transistor.

Therefore, when channel width W is set to be wide and channel length L is set to be short, $g_{mN}$ is increased, and output impedance $Z_{out}$ is decreased.

In a noninversion amplifier shown in Fig. 12, the connection relationship between first and second source follower circuits SF1 and $SF_2$ is re-

versed to that shown in Fig. 10, and the voltage gain = 1 and low output impedance $Z_{out}$ can be obtained in the same manner as described above.

A noninversion amplifier shown in Fig. 13 comprises first inverter $IV_1$ in which p-channel transistor $TP_5$, the gate of which receives input voltage $V_{in}$, and n-channel transistor $TN_5$, the drain and gate of which are connected, are connected in series with each other between VDD and VSS power supply nodes, and second inverter $IV_2$ in which p-channel transistor $TP_6$, the gate and drain of which are connected to each other, and n-channel transistor $TN_6$, the gate of which is connected to the drain of p-channel transistor $TP_5$, are connected in series with each other between the $V_{DD}$ and $V_{SS}$ power supply nodes. In this noninversion amplifier, if the transconductance, a small change in gate input voltage, a small current, and a small change in drain output voltage of n-channel transistor $TN_6$ are respectively given $g_{mN}$, $\Delta V_{in}$, $\Delta_i$, and $\Delta V_{out}$, and the transconductance of p-channel transistor $TP_6$ is given by $g_{mP}$, the following equations are established:

$$\Delta i = g_{mN} \cdot \Delta V_{in} \qquad (17)$$
$$\Delta i = g_{mP} \cdot \Delta V_{out} \qquad (18)$$

Voltage gain $K_2$ and output impedance $Z_{out}$ of second inverter $IV_2$ are respectively given by:

$$K_2 = \Delta V_{out}/\Delta V_{in} = g_{mN}/g_{mP} \qquad (19)$$
$$Z_{out} = \Delta V_{out}/\Delta i = 1/g_{mP} \qquad (20)$$

If the transconductances of p- and n-channel transistors $TP_5$ and $TN_5$ are respectively given as $g_{mP5}$ and $g_{mN5}$, the voltage gain of first inverter $IV_1$ is given by:

$$K_1 = g_{mP5}/g_{mN5} \qquad (21)$$

Therefore, if $g_{mP5} = g_{mN5}$ and $g_{mN} = g_{mP}$, then $K_1 = 1$ and $K_2 = 1$, voltage gain K of the noninversion amplifier is $K_1 \times K_2 = 1$.

In a noninversion amplifier shown in Fig. 14, the connection relationship between first and second inverters $IV_1$ and $IV_2$ is reversed to that shown in Fig. 13 described above. Thus, the voltage gain = 1 and low output impedance $Z_{out}$ can be obtained in the same manner as described above.

An A/D conversion operation of the successive approximation A/D converter shown in Fig. 5 is substantially the same as that of the conventional successive approximation A/D converter described with reference to Fig. 1, except in the following points. More specifically, in this embodiment, voltage gain K and output impedance $Z_{out}$ of inversion amplifier $A_0$ are respectively determined by high voltage gain K of inversion amplifier $A_1$ and low output impedance $Z_{out}$ of noninversion amplifier $A_2$. Therefore, a high-precision, high-speed A/D conversion can be realized.

In the above embodiment, two amplifiers $A_1$ and $A_2$ are cascade-connected as inversion amplifier $A_0$. However, the present invention is not limited to this. For example, three or more amplifiers may be cascade-connected, so that an amplifier having a low output impedance constitutes a final stage, and at least one amplifier having a high voltage gain constitutes a stage which precedes the amplifier having the low output impedance. Thus, an inversion amplifier having a high voltage gain and a low output impedance can be realized.

In the embodiment of the present invention shown in Fig. 5, inversion amplifier $A_1$ comprises an amplifier having a high voltage gain, and noninversion amplifier $A_2$ comprises an amplifier having a low output impedance. However, a noninversion amplifier may comprise an amplifier having a high voltage gain, and an inversion amplifier may comprise an amplifier having a high output impedance.

In the above embodiment, a capacitor-array charge re-distribution type local D/A converter is used. However, the present invention is not limited to this. For example, in the case of successive approximation D/A converter D shown in Fig. 15, a resistor-segment type local D/A converter D is used, switch circuit SW1 which is turned on in a sample mode ($\phi$ = "1") is connected between analog input terminal 1 and capacitor $C_0$, and switch circuit SW2 which is turned on in an approximation mode ($\overline{\phi}$ = "1") is connected between the analog output terminal of local D/A converter D and one terminal of capacitor $C_0$. The other terminal of capacitor $C_0$ is connected to voltage approximation inversion amplifier $A_0$ and switch circuit SW. The output terminal of inversion amplifier $A_0$ is connected to successive approximation control circuit B. Thus, the successive approximation control signal output from successive approximation control circuit B is supplied to local D/A converter D.

## Claims

1. A circuit ($SL_1$, $SL_2$, $SL_3$, $SL_4$, $SW_1$) which samples an analog input signal in a sample mode and supplies it to one terminal side of a capacitor ($C_1$, $C_2$, $C_3$, $C_4$, $C_0$), a circuit ($SL_1$, $SL_2$, $SL_3$, $SL_4$, $SW_2$) for supplying a local analog signal to one terminal of said capacitor ($C_1$, $C_2$, $C_3$, $C_4$, $C_0$) in an approximation mode, a voltage comparator (A0, SW) having its input terminal connected to the other terminal side of said capacitor ($C_1$, $C_2$, $C_3$, $C_4$, $C_0$) to compare an input terminal voltage in said sample mode with an input terminal voltage in said approximation mode, a local D/A converter ($SL_1$, $SL_2$, $SL_3$, $SL_4$, $C_1$, $C_2$, $C_3$, $C_4$, D) for generating said local analog signal on the basis of a successive approximation control digital signal when said comparison mode is involved, a local D/A converter ($SL_1$, $SL_2$, $SL_3$, $SL_4$, $C_1$, $C_2$, $C_3$, $C_4$, D) for generating a local analog signal based on a successive approximation control digital signal to said input terminal of said voltage comparator ($A_0$, SW) through said capacitor ($C_1$, $C_2$, $C_3$, $C_4$, $C_0$) in the approximation mode, and a successive approximation control circuit (B) for successively outputting the successive approximation control digital signal in the approximation mode, and successively determining values of bits of an A/D conversion output based on a logic level of an output from said voltage comparator ($A_0$, SW), characterized in that said voltage comparator ($A_0$, SW) comprises: a plurality of cascade-connected amplifiers ($A_1$, $A_2$) arranged such that an amplifier ($A_2$) having a lower output impedance than that of an amplifier ($A_1$) of a preceding stage constitutes a final stage of said plurality of amplifiers ($A_1$, $A_2$) and at least one amplifier ($A_1$) having a higher voltage gain than that of said amplifier ($A_2$) of the final stage constitutes a stage preceding said amplifier ($A_2$) of the final stage; and a switch circuit (SW) connected between said input terminal and an output terminal of said voltage comparator, whereby said voltage comparator compares the input terminal voltage in the sample mode with the input terminal voltage in the approximation mode.

2. A successive approximation A/D converter according to claim 1, characterized in that a circuit ($SL_1$, $SL_2$, $SL_3$, $SL_4$, $SW_1$) for supplying said analog input signal to one terminal side of said capacitor ($C_1$, $C_2$, $C_3$, $C_4$, $C_0$), a circuit ($SL_1$, $SL_2$, $SL_3$, $SL_4$, $SW_2$) for supplying said local analog signal to one terminal side of said capacitor ($C_1$, $C_2$, $C_3$, $C_4$, $C_0$), said capacitor ($C_1$, $C_2$, $C_3$, $C_4$, $C_0$) and said local D/A converter ($SL_1$, $SL_2$, $SL_3$, $SL_4$, $C_1$, $C_2$, $C_3$, $C_4$, D) constitute a capacitor array type charge redistributed D/A converter ($SL_1$, $SL_2$, $SL_3$, $SL_4$, $C_1$, $C_2$, $C_3$, $C_4$), said capacitor array type charge redistributed D/A converter having a confined function of said two circuits, said capacitor and said local D/A converter.

3. An A/D converter according to claim 1, characterized in that said amplifier ($A_2$) having the lower output impedance comprises a source follower circuit, and said amplifier ($A_1$) having the higher voltage gain comprises one of a CMOS inverter and a drain follower circuit.

4. An A/D converter according to claim 1, characterized in that said amplifier ($A_2$) having the lower output impedance comprises a noninversion amplifier, and said amplifier ($A_1$) having the higher voltage gain comprises an inversion amplifier.

5. An A/D converter according to claim 1, characterized in that said amplifier ($A_2$) having the lower output impedance comprises an inversion amplifier, and said amplifier ($A_1$) having the higher voltage gain comprises a noninversion amplifier.

6. An A/D converter according to claim 1, characterized in that said A/D converter comprises a MOS integrated circuit.

F I G. 1

F I G. 2

F I G. 3

F I G. 4

F I G. 5

F I G. 6

F I G. 7

F I G. 8

F I G. 9

F I G. 10

F I G. 11A

F I G. 11B

F I G. 12

F I G. 13

F I G. 14

F I G. 15